# EUROPEAN PATENT APPLICATION

(11) **EP 4 568 108 A1**
(43) Date of publication of application: **11.06.2025**
(21) Application number: 24216780.7
(22) Date of filing: 02.12.2024
(51) Int. Cl.: H03F 3/45, H03F 1/02, H03F 3/195, H04L 25/02

(54) **LOW POWER DC-AC COUPLED PRE-AMPLIFIER CIRCUITS FOR HIGH-SPEED LINK RECEIVERS**

(30) Priority: 04.12.2023 US 202363605946 P; 25.11.2024 US 202418959362
(71) Applicant: STMicroelectronics International N.V., 1228 Plan-les-Ouates, Geneva (CH)
(72) Inventor: VASHISHTHA, Sameer, 201306 GREATER NOIDA (IN); RIZVI, Saiyid Mohammad Irshad, 110051 NEW DELHI (IN); GARG, Paras, 201301 NOIDA (IN)
(74) Representative: Casalonga

(57) **Abstract**

A receiver includes a pre-amplifier circuit (102) and an amplifier circuit (104). The pre-amplifier circuit (102) includes first and second input terminals that receive signals from a transmitter; first and second output terminals that output signals to the amplifier circuit (104); a first resistor having a first terminal coupled to the first input terminal, and a second terminal coupled to a first node (N₁); a second resistor having a first terminal coupled to the second input terminal, and a second terminal coupled to the first node (N₁); a third resistor having a first terminal coupled to the first output terminal, and a second terminal coupled to a second node (N₂); a fourth resistor having a first terminal coupled to the second output terminal, and a second terminal coupled to the second node (N₂); and a switch (S) having a first terminal coupled to the first node (N₁), and a second terminal coupled to the second node (N₂).

## Description

### BACKGROUND

### Technical Field

The present disclosure relates generally to pre-amplifier circuits, and more particularly to low power Direct Current (DC) to Alternating Current (AC) pre-amplifier circuits for high-speed link receivers that enable AC-coupled transmission without additional power consumption.

### Description of the Related Art

Conventionally, a receiver may receive data in two modes, including a DC-coupled mode and an AC-coupled mode. In the DC-coupled mode, a common mode level V_{CM-TX} of signals transmitted by a transmitter must be aligned with a common mode level V_{CM-RX} of the receiver. In the AC-coupled mode, the common mode level V_{CM-TX} of signals transmitted by the transmitter is not necessarily aligned with the common mode level V_{CM-RX} of the receiver, which requires use of additional circuitry that consumes additional power. More particularly, in conventional on-chip DC-AC coupling schemes, a switchable internal common mode generation circuit must be added to provide AC-coupled data transmission along with DC coupled data transmission. For example, the common mode generation circuit includes resistors and a level shifter. Addition of the common mode generation circuit results in additional power consumption overhead when a link is operating in an AC-coupled mode.

### BRIEF SUMMARY

According to the present disclosure, a DC-AC pre-amplifier circuit for a high-speed link receiver does not include an input common mode generation circuit that is required by convention receivers, which results in reduced power consumption during AC-coupled transmission compared to convention receivers. To enable reduced power consumption, a DC-AC pre-amplifier circuit according to the present disclosure uses an internal common mode signal to generate an input common mode signal while a high-speed link receiver to which the DC-AC pre-amplifier circuit is electrically coupled is operating in the AC-coupled mode. Thus, no additional current is consumed while the receiver is operating in the AC-coupled mode.

A receiver according to the present disclosure may be characterized as including a pre-amplifier circuit, and an amplifier circuit which, in operation, generates an amplified signal based on output signals provided by the pre-amplifier circuit. The pre-amplifier circuit includes: a first output terminal and a second output terminal that, in operation, provide the output signals to the amplifier circuit; a first input terminal; a second input terminal; a first resistor having a first terminal electrically coupled to the first input terminal, and a second terminal electrically coupled to a first node; a second resistor having a first terminal electrically coupled to the second input terminal, and a second terminal electrically coupled to the first node; a third resistor having a first terminal electrically coupled to the first output terminal, and a second terminal electrically coupled to a second node; a fourth resistor having a first terminal electrically coupled to the second output terminal, and a second terminal electrically coupled to the second node; and a switch having a first terminal electrically coupled to the first node, and a second terminal electrically coupled to the second node.

The pre-amplifier circuit may operate in a direct current coupling mode while the switch is in a non-conductive state, and may operate in an alternating current coupling mode while the switch is in a conductive state.

An average of a voltage at the first output terminal and a voltage at the second output terminal may be provided to the first node while the switch is in a conductive state, and the average of the voltage at the first output terminal and the voltage at the second output terminal may not be provided to the first node while the switch is in a non-conductive state.

A resistance of the first resistor may be equal to a resistance of the second resistor, and a resistance of the third resistor may be equal to a resistance of the fourth resistor.

The pre-amplifier circuit may further include: a fifth resistor having a first terminal electrically coupled to a power supply voltage, and a second terminal electrically coupled to the second output terminal; a sixth resistor having a first terminal electrically coupled to the power supply voltage, and a second terminal electrically coupled to the first output terminal; a first transistor having a first terminal electrically coupled to the second input terminal, a second terminal electrically coupled to the first output terminal, and a third terminal; a second transistor having a first terminal electrically coupled to the first input terminal, a second terminal electrically coupled to the second output terminal, a third terminal electrically coupled to the third terminal of the first transistor; and a third transistor having a first terminal electrically coupled to a bias voltage potential, a second terminal electrically coupled to the third terminal of the first transistor and the third terminal of the second transistor, and a third terminal electrically coupled a ground potential. A resistance of the first resistor may be equal to a resistance of the second resistor, a resistance of the third resistor may be equal to a resistance of the fourth resistor, and a resistance of the fifth resistor may be equal to a resistance of the sixth resistor.

A pre-amplifier circuit according to the present disclosure may be characterized as including: a first input terminal; a second input terminal; a first output terminal; a second output terminal; a first resistor having a first terminal electrically coupled to the first input terminal, and a second terminal electrically coupled to a first node; a second resistor having a first terminal electrically coupled to the second input terminal, and a second terminal electrically coupled to the first node; a first transistor having a first terminal electrically coupled to the second input terminal, a second terminal electrically coupled to the first output terminal, and a third terminal; a second transistor having a first terminal electrically coupled to the first input terminal, a second terminal electrically coupled to the second output terminal, a third terminal electrically coupled to the third terminal of the first transistor; a third resistor having a first terminal electrically coupled to a power supply voltage, and a second terminal electrically coupled to the second output terminal; a fourth resistor having a first terminal electrically coupled to the power supply voltage, and a second terminal electrically coupled to the first output terminal; a fifth resistor having a first terminal electrically coupled to the second output terminal, and a second terminal electrically coupled to a second node; a sixth resistor having a first terminal electrically coupled to the first output terminal, and a second terminal electrically coupled to the second node; and a switch having a first terminal electrically coupled to the first node, and a second terminal electrically coupled to the second node.

Each of the first terminal of the first transistor and the first terminal of the second transistor may be a gate terminal, each of the second terminal of the first transistor and the second terminal of the second transistor may be a drain terminal, and each of the third terminal of the first transistor and the third terminal of the second transistor may be a source terminal.

The pre-amplifier circuit may further include: a third transistor having a first terminal electrically coupled to a bias voltage potential, a second terminal electrically coupled to the third terminal of the first transistor and the third terminal of the second transistor, and a third terminal electrically coupled a ground potential. Each of the first terminal of the first transistor, the first terminal of the second transistor, and the first terminal of the third transistor may be a gate terminal, each of the second terminal of the first transistor, the second terminal of the second transistor, and the second terminal of the third transistor may be a drain terminal, and each of the third terminal of the first transistor, the third terminal of the second transistor, and the third terminal of the third transistor may be a source terminal.

The pre-amplifier circuit may operate in a direct current coupling mode while the switch is in a non-conductive state, and may operate in an alternating current coupling mode while the switch is in a conductive state.

An average of a voltage at the first output terminal and a voltage at the second output terminal may be provided to the first node while the switch is in a conductive state, and the average of the voltage at the first output terminal and the voltage at the second output terminal may not be provided to the first node while the switch is in a non-conductive state.

The pre-amplifier circuit may further include: a first capacitor coupled to the first input terminal; and a second capacitor coupled to the second input terminal. The first capacitor and the second capacitor, in operation, may block direct current signals from entering the first input terminal and the second input terminal.

A resistance of the first resistor may be equal to a resistance of the second resistor, a resistance of the third resistor is equal to a resistance of the fourth resistor, and a resistance of the fifth resistor is equal to a resistance of the sixth resistor.

A method of operating a receiver, which includes a pre-amplifier circuit and an amplifier circuit, according to the present disclosure may be characterized as including: electrically coupling a first output terminal of the pre-amplifier circuit to the amplifier circuit; electrically coupling a second output terminal of the pre-amplifier circuit to the amplifier circuit; electrically coupling a first terminal of a first resistor to a first input terminal of the pre-amplifier circuit; electrically coupling a second terminal of the first resistor to a first node of the pre-amplifier circuit; electrically coupling a first terminal of a second resistor to a second input terminal of the pre-amplifier circuit; electrically coupling a second terminal of the second resistor to the first node of the pre-amplifier circuit; electrically coupling a first terminal of a third resistor to the first output terminal of the pre-amplifier circuit; electrically coupling a second terminal of the third resistor to a second node of the pre-amplifier circuit; electrically coupling a first terminal of a fourth resistor to the second output terminal of the pre-amplifier circuit; electrically coupling a second terminal of the fourth resistor to the second node of the pre-amplifier circuit; electrically coupling a first terminal of a switch to the first node of the pre-amplifier circuit; electrically coupling a second terminal of the switch to the second node of the pre-amplifier circuit.

The method may further include: operating the pre-amplifier circuit in a direct current coupling mode while the switch is in a non-conductive state, and operating the pre-amplifier circuit in an alternating current coupling mode while the switch is in a conductive state.

The method may further include: providing an average of a voltage at the first output terminal and a voltage at the second output terminal to the first node while the switch is in a conductive state. The average of the voltage at the first output terminal and the voltage at the second output terminal may not be provided to the first node while the switch is in a non-conductive state.

A resistance of the first resistor may be equal to a resistance of the second resistor, and a resistance of the third resistor may be equal to a resistance of the fourth resistor.

The method may further include: electrically coupling a first terminal of a fifth resistor to a power supply voltage; electrically coupling a second terminal of a fifth resistor to the second output terminal; electrically coupling a first terminal of a sixth resistor to the power supply voltage; electrically coupling a second terminal of the sixth resistor to the first output terminal; electrically coupling a first terminal of a first transistor to the second input terminal; electrically coupling a second terminal of the first transistor to the first output terminal; electrically coupling a first terminal of a second transistor to the first input terminal; electrically coupling a second terminal of the second transistor to the second output terminal; electrically coupling a third terminal of the second transistor to a third terminal of the first transistor; electrically coupling a first terminal of a third transistor to a bias voltage potential; electrically coupling a second terminal of the third transistor to the third terminal of the first transistor and the third terminal of the second transistor; and electrically coupling a third terminal of the third transistor to a ground potential.

### BRIEF DESCRIPTION OF THE SEVERAL VIEWS OF THE DRAWINGS

Non-limiting and non-exhaustive embodiments are described with reference to the following drawings. In the drawings, like reference numerals refer to like parts throughout the various figures unless otherwise specified.

For a better understanding of the present disclosure, reference will be made to the following Detailed Description, which is to be read in association with the accompanying drawings:
Figure 1 shows a block diagram of a receiver according to an embodiment of the present disclosure.
Figure 2 is diagram for explaining operation of the receiver shown in Figure 1 in a DC-coupled mode.
Figure 3 is diagram for explaining operation of the receiver shown in Figure 1 in an AC-coupled mode.

### DETAILED DESCRIPTION

According to the present disclosure, an output common mode signal from a pre-amplifier stage of a receiver (e.g., high-speed link receiver) is used to provide an input common mode signal for input data when the receiver operates in an AC-coupling mode. Thus, receivers according to the present disclosure do not consume additional current while operating in the AC-coupling mode.

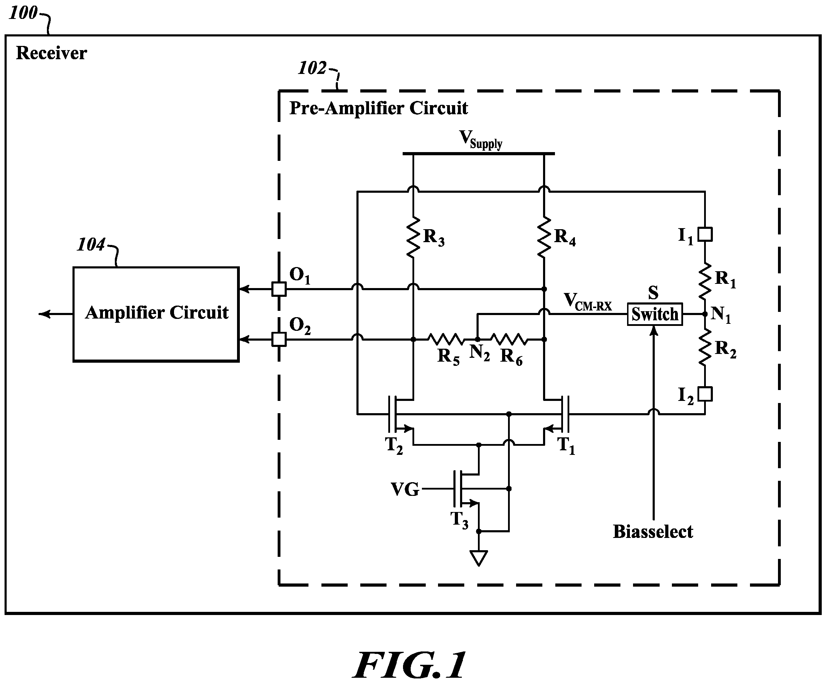

Figure 1 shows a block diagram of a receiver 100 according to an embodiment of the present disclosure. The receiver includes a pre-amplifier circuit 102 and an amplifier circuit 104. In one or more implementations, the receiver 100 is a high-speed link receiver, which may include additional circuitry (not shown) that demodulates a signal output by the amplifier circuit 104, for example. In one or more implementations, the amplifier circuit 104 includes a differential amplifier, such as an operational amplifier. In one or more implementations, the amplifier circuit 104 is an amplifying and differential-to-single-ended-conversion circuit.

The pre-amplifier circuit 102 includes an input terminal I₁ and an input terminal I₂ through which the pre-amplifier circuit 102 receives signals transmitted by a transmitter (not illustrated). The input terminal I₁ is a positive data input terminal, and the input terminal I₂ is a negative data input terminal. The pre-amplifier circuit 102 also includes an output terminal O₁ and an output terminal O₂ through which the pre-amplifier circuit 102 provides signals to the amplifier circuit 104.

In addition, the pre-amplifier circuit 102 includes a transistor T₁, a transistor T₂, and a transistor T₃. In one or more implementations, each of the transistors T₁, T₂, and T₃ is an N-channel metal-oxide-semiconductor field-effect transistor (MOSFET) that includes a gate terminal, a drain terminal, a source terminal, and a body terminal.

More particularly, the gate terminal of the transistor T₁ is electrically coupled to the input terminal I₂, the drain terminal of the transistor T₁ is electrically coupled to the output terminal O₁, and the source terminal of the transistor T₁ is electrically coupled to the source terminal of the transistor T₂. The gate terminal of the transistor T₂ is electrically coupled to the input terminal I₁, the drain terminal of the transistor T₂ is electrically coupled to the output terminal O₂, and the source terminal of the transistor T₂ is electrically coupled to the source terminal of the transistor T₁. The gate terminal of the transistor T₃ is electrically coupled to a bias voltage potential VG, the drain terminal of the transistor T₃ is electrically coupled to the source terminal of the transistor T₁ and the source terminal of the transistor T₂, and the source terminal of the transistor T₃ is electrically coupled to a ground potential. Additionally, the body terminals of the transistors T₁, T₂, and T₃ are electrically connected to the ground potential.

The pre-amplifier circuit 102 also includes a resistor R₁, a resistor R₂, a resistor R₃, a resistor R₄, a resistor R₅, and a resistor R₆. Each of the resistors R₁, R₂, R₃, R₄, R₅, and R₆ includes a first terminal and second terminal. More particularly, the first terminal of the resistor R₁ is electrically coupled to the input terminal I₁, and the second terminal of the R₁ is electrically coupled to a node N₁. The first terminal of the resistor R₂ is electrically coupled to the input terminal I₂, and the second terminal of the resistor R₂ is electrically coupled to the node N₁. The first terminal of the resistor R₃ is electrically coupled to a power supply voltage V_{supply}, and the second terminal of the resistor R₃ is electrically coupled to the output terminal O₂. The first terminal of the resistor R₄ is electrically coupled to the power supply voltage V_{supply}, and the second terminal of the resistor R₄ is electrically coupled to the output terminal O₁. The first terminal of the resistor R₅ is electrically coupled to the output terminal O₂, and the second terminal of the resistor R₅ is electrically coupled to a node N₂. The first terminal of the resistor R₆ is electrically coupled to the output terminal O₁, and the second terminal of the resistor R₆ is electrically coupled to the node N₂.

In one embodiment, each of the resistors R₁ and R₂ is a 50 Ohm resistor. Each of the resistors R₃ and R₄ is a1 KOhm resistor. Each of the resistors R₅ and R₆ is 10 KOhm resistor. Also, the supply voltage V_{supply} is 1.8 Volts.

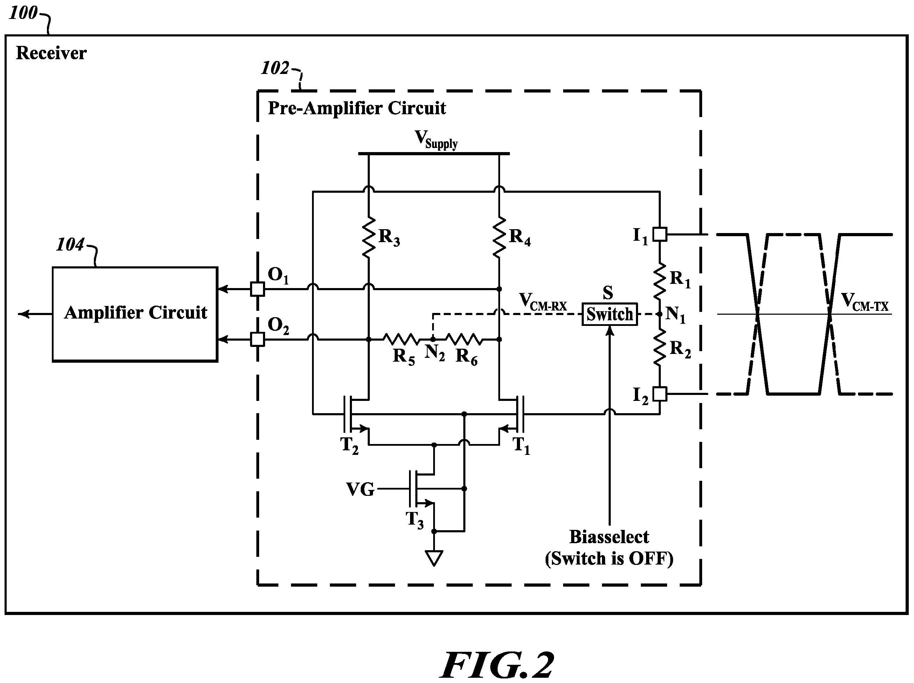

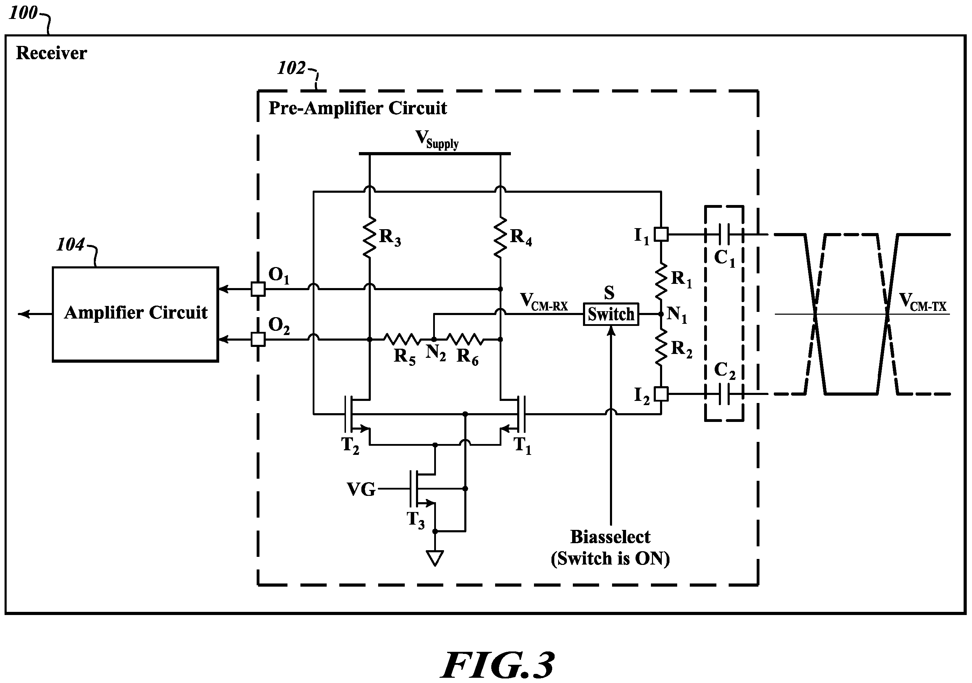

Additionally, the pre-amplifier circuit 102 includes a switch S including a first terminal, a second terminal, and a third terminal through which the switch S receives a control signal Biasselect from control circuitry (not illustrated). The first terminal of the switch S is electrically coupled to the node N₁, and the second terminal of the switch S is electrically coupled to the second node N₂. While the control signal Biasselect has a first characteristic (e.g., voltage level), the switch S is in a conductive state in which the first terminal is electrically coupled to the second terminal. While the control signal Biasselect has a second characteristic (e.g., voltage level), the switch S is in a nonconductive state in which the first terminal is not electrically coupled to the second terminal. While the switch S is in the non-conductive state, the pre-amplifier circuit operates 102 in a DC-coupling mode in which DC signals are not blocked from entering the pre-amplifier circuit 102 through the input terminal I₁ and the input terminal I₂, as will be explained with reference to Figure 2. While the switch S is in the conductive state, the pre-amplifier circuit 102 operates in an AC-coupling mode in which DC signals are blocked from entering the pre-amplifier circuit 102 through the input terminal I₁ and the input terminal I₂, as will be explained with reference to Figure 3.

Figure 2 is diagram for explaining operation of the receiver 100 in the DC-coupled mode. In Figure 2, the switch S receives the control signal Biasselect that causes the switch S to be in the non-conductive state. Accordingly, the node N₁ is not electrically coupled to the node N₂. Thus, a common mode receiver voltage V_{CM-RX}, which is a voltage at the node N₂, is not used to bias the common mode transmitter voltage V_{CM-TX}, which is the average voltage level of the signals input to the input terminals I₁ and I₂.

Figure 3 is diagram for explaining operation of the receiver 100 in an AC-coupled mode. In Figure 3, the switch S receives the control signal Biasselect that causes the switch S to be in the conductive state. Accordingly, the node N₁ is electrically coupled to the node N₂. The common mode receiver voltage V_{CM-RX} is the average of the voltage at output terminal O₁ and the voltage at the output terminal O₂, which is provided to the node N₁ in order to bias the common mode transmitter voltage V_{CM-TX}, which is the average the voltage level at the input terminal I₁ and the voltage level at the input terminal I₂. Accordingly, the common mode transmitter voltage V_{CM-TX} becomes aligned with the common mode receiver voltage V_{CM-RX}, and the receiver 100 is able to correctly receive signals from a transmitter having a common mode voltage that is different from the common mode voltage of the receiver 100. Thus, while the receiver 100 operates in the AC-coupling mode (*i.e.,* the switch is in the conductive state), and the receiver 100 can be driven by any transmitter without any common mode constraint.

The various embodiments described above can be combined to provide further embodiments. Aspects of the embodiments can be modified, if necessary to employ concepts of the various patents, applications and publications to provide yet further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A receiver, comprising:
a pre-amplifier circuit; and
an amplifier circuit which, in operation, generates an amplified signal based on output signals provided by the pre-amplifier circuit,
wherein the pre-amplifier circuit includes:
a first output terminal and a second output terminal that, in operation, provide the output signals to the amplifier circuit;
a first input terminal;
a second input terminal;
a first resistor having a first terminal electrically coupled to the first input terminal, and a second terminal electrically coupled to a first node;
a second resistor having a first terminal electrically coupled to the second input terminal, and a second terminal electrically coupled to the first node;
a third resistor having a first terminal electrically coupled to the first output terminal, and a second terminal electrically coupled to a second node;
a fourth resistor having a first terminal electrically coupled to the second output terminal, and a second terminal electrically coupled to the second node; and
a switch having a first terminal electrically coupled to the first node, and a second terminal electrically coupled to the second node.

2. The receiver according to claim 1, wherein:
the pre-amplifier circuit operates in a direct current coupling mode while the switch is in a non-conductive state, and
the pre-amplifier circuit operates in an alternating current coupling mode while the switch is in a conductive state.

3. The receiver according to claim 1, wherein:
an average of a voltage at the first output terminal and a voltage at the second output terminal is provided to the first node while the switch is in a conductive state, and
the average of the voltage at the first output terminal and the voltage at the second output terminal is not provided to the first node while the switch is in a non-conductive state.

4. The receiver according to claim 1 wherein:
a resistance of the first resistor is equal to a resistance of the second resistor, and
a resistance of the third resistor is equal to a resistance of the fourth resistor.

5. The receiver according to claim 1, wherein the pre-amplifier circuit further comprises:
a fifth resistor having a first terminal electrically coupled to a power supply voltage, and a second terminal electrically coupled to the second output terminal;
a sixth resistor having a first terminal electrically coupled to the power supply voltage, and a second terminal electrically coupled to the first output terminal;
a first transistor having a first terminal electrically coupled to the second input terminal, a second terminal electrically coupled to the first output terminal, and a third terminal;
a second transistor having a first terminal electrically coupled to the first input terminal, a second terminal electrically coupled to the second output terminal, a third terminal electrically coupled to the third terminal of the first transistor; and
a third transistor having a first terminal electrically coupled to a bias voltage potential, a second terminal electrically coupled to the third terminal of the first transistor and the third terminal of the second transistor, and a third terminal electrically coupled a ground potential.

6. The receiver according to claim 5, wherein:
a resistance of the first resistor is equal to a resistance of the second resistor,
a resistance of the third resistor is equal to a resistance of the fourth resistor, and
a resistance of the fifth resistor is equal to a resistance of the sixth resistor.

7. A pre-amplifier circuit, comprising:
a first input terminal;
a second input terminal;
a first output terminal;
a second output terminal;
a first resistor having a first terminal electrically coupled to the first input terminal, and a second terminal electrically coupled to a first node;
a second resistor having a first terminal electrically coupled to the second input terminal, and a second terminal electrically coupled to the first node;
a first transistor having a first terminal electrically coupled to the second input terminal, a second terminal electrically coupled to the first output terminal, and a third terminal;
a second transistor having a first terminal electrically coupled to the first input terminal, a second terminal electrically coupled to the second output terminal, a third terminal electrically coupled to the third terminal of the first transistor;
a third resistor having a first terminal electrically coupled to a power supply voltage, and a second terminal electrically coupled to the second output terminal;
a fourth resistor having a first terminal electrically coupled to the power supply voltage, and a second terminal electrically coupled to the first output terminal;
a fifth resistor having a first terminal electrically coupled to the second output terminal, and a second terminal electrically coupled to a second node;
a sixth resistor having a first terminal electrically coupled to the first output terminal, and a second terminal electrically coupled to the second node; and
a switch having a first terminal electrically coupled to the first node, and a second terminal electrically coupled to the second node.

8. The pre-amplifier circuit according to claim 7, wherein:
each of the first terminal of the first transistor and the first terminal of the second transistor is a gate terminal,
each of the second terminal of the first transistor and the second terminal of the second transistor is a drain terminal, and
each of the third terminal of the first transistor and the third terminal of the second transistor is a source terminal.

9. The pre-amplifier circuit according to claim 7, further comprising:
a third transistor having a first terminal electrically coupled to a bias voltage potential, a second terminal electrically coupled to the third terminal of the first transistor and the third terminal of the second transistor, and a third terminal electrically coupled a ground potential.

10. The pre-amplifier circuit according to claim 9, wherein:
each of the first terminal of the first transistor, the first terminal of the second transistor, and the first terminal of the third transistor is a gate terminal,
each of the second terminal of the first transistor, the second terminal of the second transistor, and the second terminal of the third transistor is a drain terminal, and
each of the third terminal of the first transistor, the third terminal of the second transistor, and the third terminal of the third transistor is a source terminal.

11. The pre-amplifier circuit according to claim 7, wherein:
the pre-amplifier circuit operates in a direct current coupling mode while the switch is in a non-conductive state, and
the pre-amplifier circuit operates in an alternating current coupling mode while the switch is in a conductive state.

12. The pre-amplifier circuit according to claim 7, wherein:
an average of a voltage at the first output terminal and a voltage at the second output terminal is provided to the first node while the switch is in a conductive state, and
the average of the voltage at the first output terminal and the voltage at the second output terminal is not provided to the first node while the switch is in a non-conductive state.

13. The pre-amplifier circuit according to claim 7, further comprising:
a first capacitor coupled to the first input terminal; and
a second capacitor coupled to the second input terminal.

14. The pre-amplifier circuit according to claim 13, wherein:
the first capacitor and the second capacitor, in operation, block direct current signals from entering the first input terminal and the second input terminal.

15. The pre-amplifier circuit according to claim 7, wherein:
a resistance of the first resistor is equal to a resistance of the second resistor,
a resistance of the third resistor is equal to a resistance of the fourth resistor, and
a resistance of the fifth resistor is equal to a resistance of the sixth resistor.

16. A method of operating a receiver that includes a pre-amplifier circuit and an amplifier circuit, the method comprising:
electrically coupling a first output terminal of the pre-amplifier circuit to the amplifier circuit;
electrically coupling a second output terminal of the pre-amplifier circuit to the amplifier circuit;
electrically coupling a first terminal of a first resistor to a first input terminal of the pre-amplifier circuit;
electrically coupling a second terminal of the first resistor to a first node of the pre-amplifier circuit;
electrically coupling a first terminal of a second resistor to a second input terminal of the pre-amplifier circuit;
electrically coupling a second terminal of the second resistor to the first node of the pre-amplifier circuit;
electrically coupling a first terminal of a third resistor to the first output terminal of the pre-amplifier circuit;
electrically coupling a second terminal of the third resistor to a second node of the pre-amplifier circuit;
electrically coupling a first terminal of a fourth resistor to the second output terminal of the pre-amplifier circuit;
electrically coupling a second terminal of the fourth resistor to the second node of the pre-amplifier circuit;
electrically coupling a first terminal of a switch to the first node of the pre-amplifier circuit;
electrically coupling a second terminal of the switch to the second node of the pre-amplifier circuit.

17. The method according to claim 16, further comprising:
operating the pre-amplifier circuit in a direct current coupling mode while the switch is in a non-conductive state, and
operating the pre-amplifier circuit in an alternating current coupling mode while the switch is in a conductive state.

18. The method according to claim 16, further comprising:
providing an average of a voltage at the first output terminal and a voltage at the second output terminal to the first node while the switch is in a conductive state,
wherein the average of the voltage at the first output terminal and the voltage at the second output terminal is not provided to the first node while the switch is in a non-conductive state.

19. The method according to claim 16 wherein:
a resistance of the first resistor is equal to a resistance of the second resistor, and
a resistance of the third resistor is equal to a resistance of the fourth resistor.

20. The method according to claim 16, further comprising:
electrically coupling a first terminal of a fifth resistor to a power supply voltage;
electrically coupling a second terminal of a fifth resistor to the second output terminal;
electrically coupling a first terminal of a sixth resistor to the power supply voltage;
electrically coupling a second terminal of the sixth resistor to the first output terminal;
electrically coupling a first terminal of a first transistor to the second input terminal;
electrically coupling a second terminal of the first transistor to the first output terminal;
electrically coupling a first terminal of a second transistor to the first input terminal;
electrically coupling a second terminal of the second transistor to the second output terminal;
electrically coupling a third terminal of the second transistor to a third terminal of the first transistor;
electrically coupling a first terminal of a third transistor to a bias voltage potential;
electrically coupling a second terminal of the third transistor to the third terminal of the first transistor and the third terminal of the second transistor; and
electrically coupling a third terminal of the third transistor to a ground potential.
